(19) Europäisches Patentamt
European Patent Office
Office européen des brevets

(11) **EP 3 783 317 B1**

(12) **EUROPÄISCHE PATENTSCHRIFT**

(45) Veröffentlichungstag und Bekanntmachung des Hinweises auf die Patenterteilung:
**19.01.2022 Patentblatt 2022/03**

(21) Anmeldenummer: **19192531.2**

(22) Anmeldetag: **20.08.2019**

(51) Internationale Patentklassifikation (IPC):
**G01D 5/244** $^{(2006.01)}$ **G01D 5/241** $^{(2006.01)}$
**G01P 15/125** $^{(2006.01)}$ **G01D 21/00** $^{(2006.01)}$

(52) Gemeinsame Patentklassifikation (CPC):
**G01D 5/24476; G01D 21/00;** G01D 5/2415;
G01P 15/125

(54) **SENSOREINRICHTUNG MIT SYNCHRONISIERUNG EINES SENSORSIGNALS AUF EIN ABFRAGESIGNAL**

SENSOR DEVICE WITH SYNCHRONISATION OF A SENSOR SIGNAL WITH AN INTERROGATION SIGNAL

DISPOSITIF CAPTEUR À SYNCHRONISATION D'UN SIGNAL DE CAPTEUR SUR UN SIGNAL D'INTERROGATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**24.02.2021 Patentblatt 2021/08**

(73) Patentinhaber: **Siemens Aktiengesellschaft 80333 München (DE)**

(72) Erfinder: **Finkler, Roland 91058 Erlangen (DE)**

(56) Entgegenhaltungen:
**EP-A1- 2 787 644    EP-A1- 2 916 107**
**DE-A1- 4 331 226    US-A- 5 317 614**

**Beschreibung**

Die vorliegende Erfindung geht aus von einer Sensoreinrichtung,

- wobei die Sensoreinrichtung einen Signalanschluss aufweist, über den der Sensoreinrichtung von einer übergeordneten Einrichtung ein digitales Abfragesignal zuführbar ist, so dass das Abfragesignal alternierend ansteigende und abfallende Flanken aufweist,
- wobei die Sensoreinrichtung in Reaktion auf das Zuführen des digitalen Abfragesignals über den Signalanschluss oder einen anderen Signalanschluss ein resultierendes Sensorsignal an die übergeordnete Einrichtung ausgibt,
- wobei die Sensoreinrichtung einen Taktgeber aufweist, der mit einer Basisfrequenz ein digitales Basissignal abgibt, so dass das Basissignal alternierend ansteigende und abfallende Flanken aufweist,
- wobei die Sensoreinrichtung einen Zähler aufweist, dem das Basissignal zugeführt wird und der einen Zählerstand ausgibt,
- wobei der Zähler den Zählerstand modulo eines Modulowertes hochzählt,
- wobei die Sensoreinrichtung eine Erregereinrichtung aufweist, welche ein Erregersignal an ein Sensorelement der Sensoreinrichtung ausgibt,
- wobei der jeweilige Zählerstand oder ein daraus abgeleiteter Wert der Erregereinrichtung zugeführt wird und die Erregereinrichtung anhand des jeweiligen Zählerstandes oder des daraus abgeleiteten Wertes bestimmt, welchen Wert das Erregersignal jeweils aufweist,
- wobei das Sensorelement aufgrund des Erregersignals ein Rohsignal abgibt,
- wobei die Sensoreinrichtung eine Auswertungseinrichtung aufweist, der das Rohsignal zugeführt wird,
- wobei der jeweilige Zählerstand oder ein daraus abgeleiteter Wert der Auswertungseinrichtung zugeführt wird und die Auswertungseinrichtung anhand des jeweiligen Zählerstandes oder des daraus abgeleiteten Wertes bestimmt, ob sie das Rohsignal erfasst und auf welche Art und Weise sie das jeweils erfasste Rohsignal bei der Ermittlung des resultierenden Sensorsignals berücksichtigt.

Derartige Sensoreinrichtungen sind allgemein bekannt.

Bei vielen Sensoreinrichtungen basiert die zeitliche Abfolge der Erfassung der Rohsignale auf einem Basistakt, der innerhalb der Sensoreinrichtung mittels eines Taktgebers generiert wird. Der Taktgeber oszilliert mit einer hohen Frequenz, die 100 MHz und mehr betragen kann. Von einer übergeordneten Einrichtung - beispielsweise einer Steuereinrichtung für einen Antrieb - wird immer wieder ein resultierendes Sensorsignal abgefragt. Die übergeordnete Steuereinrichtung führt der Sensoreinrichtung zu diesem Zweck ein entsprechendes digitales Abfragesignal zu. Auch das Zuführen des Abfragesignals erfolgt getaktet. Das Abfragesignal weist jedoch eine deutlich niedrigere Frequenz von beispielsweise 8 kHz oder 16 kHz auf. Die beiden Takte - also der Basistakt des Taktgebers innerhalb der Sensoreinrichtung und der Takt des von außen zugeführten Abfragesignals - laufen oft asynchron zueinander.

Im einfachsten Fall gibt die Sensoreinrichtung den zuletzt intern generierten Wert als resultierendes Sensorsignal aus.

Aufgrund der Asynchronizität führt diese Vorgehensweise dazu, dass das resultierende Sensorsignal gegenüber dem Abfragesignal, aufgrund dessen es an die übergeordnete Einrichtung ausgegeben wird, eine variable Totzeit aufweist. Hierbei kann sich in der Praxis die Situation ergeben, dass der Wert der Totzeit, ausgehend von einem bestimmten Wert bei einer bestimmten Abfrage von Abfrage zu Abfrage ansteigt, bis die Totzeit einen Maximalwert erreicht. Dann springt die Totzeit abrupt auf den Minimalwert und steigt danach nach und nach wieder an. Auch die umgekehrte Situation kann sich ergeben. Die Periode, mit welcher sich die Sprünge in der Totzeit ergeben, kann 100 ms und größer sein. Der Sprung der Totzeit vom Maximalwert auf den Minimalwert oder umgekehrt kann kritisch sein und insbesondere leichte Störungen einer Regelgenauigkeit bewirken, welche die übergeordnete Einrichtung beispielsweise bei einem von der übergeordneten Einrichtung gesteuerten Antrieb vornimmt.

Aus der EP 2 916 107 A1 ist bekannt, den Taktgeber innerhalb der Sensoreinrichtung auf den Abfragetakt des von außen zugeführten Abfragesignals zu synchronisieren. Zu diesem Zweck ist in der EP 2 916 107 A1 eine phasenverriegelte Schleife (phase locked loop) vorgesehen, mittels derer die Frequenz des Taktgebers innerhalb der Sensoreinrichtung nachgeführt wird.

Die Aufgabe der vorliegenden Erfindung besteht darin, auf einfache Weise innerhalb der Sensoreinrichtung eine Synchronisierung des Zählerstandes auf den Abfragetakt des von außen zugeführten Abfragesignals vornehmen zu können. Das Synchronisieren soll vorzugsweise mit rein digitalen Mitteln möglich sein. Insbesondere soll eine analog arbeitende phasenverriegelte Schleife (phase locked loop) vermieden werden.

Die Aufgabe wird durch eine Sensoreinrichtung mit den Merkmalen des Anspruchs 1 gelöst. Vorteilhafte Ausgestaltungen der Sensoreinrichtung sind Gegenstand der abhängigen Ansprüche 2 bis 14.

Erfindungsgemäß wird eine Sensoreinrichtung der eingangs genannten Art dadurch ausgestaltet,

- dass dem Zähler zusätzlich zum Basissignal auch das Abfragesignal zugeführt wird,
- dass der Zähler den Zählerstand nur dann modulo des Modulowertes hochzählt, wenn zwischen zwei unmittelbar aufeinanderfolgenden ansteigenden Flanken und/oder abfallenden Flanken des Basissignals keine ansteigende und/oder abfallende Flanke des Abfragesignals auftritt,
- dass der Zähler, sofern zwischen zwei unmittelbar aufeinanderfolgenden ansteigenden und/oder abfallenden Flanken des Basissignals eine ansteigende und/oder abfallende Flanke des Abfragesignals auftritt, vor oder nach dem Hochzählen des Zählerstandes den Zählerstand um den Abstand des Zählerstandes zum nächsten einer Anzahl von besonderen Zählerständen korrigiert und
- dass die besonderen Zählerstände eine echte Teilmenge der möglichen Zählerstände sind.

Die Anzahl von besonderen Zählerständen kann nach Bedarf bestimmt sein. Insbesondere kann sie gleich 1 oder größer als 1 sein. Eine Anzahl von 1 kann insbesondere dann sinnvoll sein, wenn der Quotient der Abfrageperiode und der Basisperiode hinreichend genau gleich einem ganzzahligen Vielfachen der Anzahl an möglichen Zählerständen ist.

Wenn das von der Erregereinrichtung an das Sensorelement abgegebene Erregersignal, bezogen auf die Abfolge der Zählerstände, während aufeinanderfolgender, in sich zusammenhängender Abschnitte von Zählerständen jeweils einen konstanten Wert aufweist, ist vorzugsweise vorgesehen, dass

- dass die Abschnitte von Zählerständen jeweils zumindest in etwa die gleiche Anzahl an Zählerständen umfassen,
- die Anzahl an Abschnitten ein ganzzahliges Vielfaches der Anzahl an besonderen Zählerständen ist, insbesondere gleich der Anzahl an besonderen Zählerständen ist, und
- die besonderen Zählerstände in etwa in der Mitte des jeweiligen Abschnitts liegen.

Dadurch kann insbesondere erreicht werden, dass das gegebenenfalls erforderliche Korrigieren des Zählerstandes nicht sofort und unmittelbar mit einer Änderung des Erregersignals verbunden ist. Dies erleichtert den stabilen Betrieb der Sensoreinrichtung.

Vorzugsweise erfasst die Auswertungseinrichtung das Rohsignal ausschließlich bei bestimmten Zählerständen, wobei die bestimmten Zählerstände vorzugsweise von den Grenzen der aufeinanderfolgenden Abschnitte entfernt sind. Durch diese Vorgehensweise kann insbesondere vermieden werden, dass eine Erfassung des Rohsignals in der Nähe des transienten Zustands beim Ändern des Erregersignals vorgenommen wird. Dies kann insbesondere aus EMV-Gründen und aus Gründen der Genauigkeit des erfassten Rohsignals von Vorteil sein.

In vielen Fällen ist es von Vorteil, wenn der Modulowert gleich dem Produkt einer ersten und einer zweiten ganzen Zahl ist, wobei die erste ganze Zahl gleich der Anzahl an aufeinanderfolgenden Zählerständen ist, während derer das Erregersignal jeweils einen konstanten Wert aufweist. Hiermit korrespondierend ist die zweite ganze Zahl gleich der Anzahl an Abschnitten aufeinanderfolgender Zählerstände, während derer das Erregersignal jeweils einen konstanten Wert aufweist. Es ist möglich, dass der Sensoreinrichtung die erste und die zweite ganze Zahl fest vorgegeben sind. Vorzugsweise aber weist die Sensoreinrichtung einen Parametriereingang auf, über den der Sensoreinrichtung nach der Herstellung der Sensoreinrichtung, insbesondere bei der Inbetriebnahme der Sensoreinrichtung, die erste und die zweite ganze Zahl vorgebbar sind. Dadurch können die genannten Zahlen der Sensoreinrichtung nach Bedarf vorgegeben werden.

Sofern die Sensoreinrichtung einen Parametriereingang aufweist, kann es alternativ oder zusätzlich zur Vorgabe der genannten Zahlen möglich sein, dass der Sensoreinrichtung nach der Herstellung der Sensoreinrichtung, insbesondere bei der Inbetriebnahme der Sensoreinrichtung, über den Parametriereingang die Anzahl an besonderen Zählerständen vorgebbar ist.

Ebenso kann es alternativ oder zusätzlich zur Vorgabe der genannten Zahlen und/oder der Anzahl an besonderen Zählerständen möglich sein, dass der Sensoreinrichtung nach der Herstellung der Sensoreinrichtung, insbesondere bei der Inbetriebnahme der Sensoreinrichtung, über den Parametriereingang mindestens ein Betriebsparameter der Erregereinrichtung und/oder des Sensorelements und/oder der Auswertungseinrichtung vorgebbar ist. Dadurch kann die Betriebsweise der Sensoreinrichtung nach Bedarf auf die Umstände der konkreten Anwendung abgestimmt werden.

Für alle Möglichkeiten der Parametrierung gilt stets, dass auch äquivalente Vorgaben möglich sind. Beispielsweise ist es möglich, anstelle der ersten und der zweiten ganzen Zahl eine dieser beiden Zahlen und das Produkt dieser beiden Zahlen vorzugeben. Ähnliche Ausführungen gelten für die anderen möglichen Parameter.

Alternativ zu einer expliziten Vorgabe von Parametern ist es möglich, dass die Sensoreinrichtung eine Parameterbestimmungseinrichtung aufweist, mittels derer die Sensoreinrichtung anhand der Abfragefrequenz mindestens einen Betriebsparameter der Sensoreinrichtung selbsttätig ermittelt. Bei diesem Betriebsparameter bzw. diesen Betriebsparametern kann es sich um einen oder mehrere der obenstehend genannten Parameter handeln. Bezüglich eines einzelnen Parameters ist diese Vorgehensweise alternativ zur Vorgabe des entsprechenden Parameters über einen Parametriereingang. Über alle Parameter insgesamt gesehen ist aber auch eine gemischte Vorgehensweise möglich, dass also mindestens einer der Parameter über den Parametriereingang vorgegeben wird und mindestens ein anderer der Parameter von der Sensoreinrichtung anhand der Abfragefrequenz selbsttätig ermittelt wird.

Schließlich ist es möglich, dass der Sensoreinrichtung über den Parametriereingang nach der Herstellung der Sensoreinrichtung, insbesondere bei der Inbetriebnahme der Sensoreinrichtung, die Abfragefrequenz als solche vorgebbar ist. Alternativ ist es auch möglich, dass das Abfragesignal innerhalb der Sensoreinrichtung der Parameterbestimmungseinrichtung zugeführt wird und die Parameterbestimmungseinrichtung die Abfragefrequenz anhand des Abfragesignals selbsttätig ermittelt.

Aufgrund des Umstands, dass die Erregereinrichtung anhand des jeweiligen Zählerstandes bestimmt, welchen Wert das Erregersignal jeweils aufweist, ist das Erregersignal, bezogen auf die Abfolge der Zählerstände, mit dem Modulowert periodisch. Vorzugsweise oszilliert das Erregersignal, bezogen auf die Abfolge der Zählerstände, mit der Grundschwingung oder einer höheren harmonischen Schwingung oder bestimmen die Grundschwingung oder die höhere harmonische Schwingung zumindest den dominanten Anteil des Erregersignals. Im Regelfall ist hierbei die Grundschwingung vorzuziehen. Es sind aber auch Situationen denkbar, in denen eine harmonische Schwingung von Vorteil ist.

Denn für ein optimales Arbeiten des Sensorelementes ist es oftmals von Vorteil, wenn das Erregersignal exakt oder zumindest wenigstens näherungsweise sinusförmig ist und die Frequenz der - gegebenenfalls angenäherten - Sinusschwingung innerhalb eines bestimmten Frequenzbereichs liegt. In einigen Fällen, beispielsweise bei Beschleunigungssensoren, ist es weiterhin von Vorteil, wenn die Frequenz der Sinusschwingung möglichst genau ein ganzzahliges Vielfaches der Abfragefrequenz ist (wobei die Identität mit der Abfragefrequenz mit umfasst sein soll).

Zur Motivation der der Verwendung einer höheren Harmonischen für das Erregersignal bzw. den dominanten Anteil des Erregersignals sei folgendes Beispiel betrachtet:
Man nehme an, das Sensorelement sei ein Beschleunigungssensor, für den es von Vorteil ist, wenn das Erregersignal näherungsweise sinusförmig mit einer Frequenz zwischen 20 kHz und 40 kHz ist und diese Frequenz außerdem ein ganzzahliges Vielfaches der Abfragefrequenz ist. Wenn beispielsweise die Basisfrequenz 50 MHz beträgt und die Abfragefrequenz 8 kHz beträgt und demzufolge die Basisperiode und die Abfrageperiode 20 ns und 125 $\mu$s betragen, ergeben sich als günstige Frequenz (Erregerfrequenz) und Periode (Erregerperiode) für das Erregersignal 32 kHz bzw. 31,25 $\mu$s.

Mit diesen Werten ist der Quotient der Erregerperiode und der Basisperiode mit 31,25$\mu$s/20ns = 1562,5 nicht ganzzahliges. Dennoch lässt sich ausgehend auf den Zählerständen ein Erregersignal generieren, welches (bezogen auf die Zeit) näherungsweise periodisch mit der Erregerperiode ist, wenn man von einem Modulowert ausgeht, der gleich dem Doppelten des Quotienten von Erregerperiode und Basisperiode ist, und für das Erregersignal beispielsweise 25 Abschnitte zu je 125 Zählerständen bildet (25 x 125 = 3125). Das Erregersignal für den i-ten Abschnitt (mit i = 1, 2, ..., 25) kann in diesem Fall beispielsweise zu E0cos(2*2*pi*(i-1)/25) bestimmt werden, wobei E0 eine prinzipiell frei wählbare Amplitude ist.

Allerdings lässt sich auch bei der Verwendung der Grundschwingung in sehr guter Näherung das gleiche Ergebnis erreichen. In diesem Fall kann man beispielsweise für die Erregerperiode von einem etwas anderen Wert ausgehen, beispielsweise einem um 10 ns kleineren Wert, also von 31,24 $\mu$s. In diesem Fall ist die Erregerfrequenz zwar nicht mehr exakt, wohl aber mit hinreichender Genauigkeit ein ganzzahliges Vielfaches der Abfragefrequenz. Außerdem ist jetzt der Quotient der Erregerperiode und der Basisperiode mit 1562 ganzzahlig. Als Modulowert kann in diesem Fall ebenfalls dieser Wert gewählt werden. Für das Erregersignal lassen sich in diesem Fall beispielsweise 12 Abschnitte vorsehen, von denen der erste und der siebte jeweils 131 Zählerstände und die anderen Abschnitte jeweils 130 Zählerstände umfassen. Das Erregersignal für den i-ten Abschnitt (mit i = 1, 2, ..., 25) kann in diesem Fall beispielsweise zu E0cos(2*pi*(i-1)/12) bestimmt werden, wobei E0 wieder eine prinzipiell frei wählbare Amplitude ist.

In manchen Fällen ist eine Ausgestaltung der Sensoreinrichtung von Vorteil, bei der

- die Auswertungseinrichtung, gerechnet ab dem zuletzt abgefragten resultierenden Sensorsignal, für jeweils eine Anzahl von Zählerständen ein vorläufiges Sensorsignal ermittelt,
- die soeben genannte Anzahl von Zählerständen gleich dem Modulowert ist,
- die Auswertungseinrichtung das jeweilige vorläufige Sensorsignal dadurch ermittelt, dass sie zunächst anhand der Rohsignale ein Zwischensignal ermittelt und anhand des jeweiligen Zwischensignals unter Verwertung einer nichtlinearen Kennlinie das jeweilige vorläufige Sensorsignal ermittelt, und
- die Auswertungseinrichtung das resultierende Sensorsignal als Mittelwert der seit dem zuletzt abgefragten resultierenden Sensorsignal ermittelten vorläufigen Sensorsignale ermittelt.

Diese Vorgehensweise kann insbesondere dann sinnvoll sein, wenn das vorläufige und das resultierende Sensorsignal die Beschleunigung des Sensorelements repräsentieren. Insbesondere wird die Beschleunigung oftmals dazu verwendet, durch nachfolgende Integration die Geschwindigkeit zu ermitteln. Durch die genannte Vorgehensweise kann die Geschwindigkeit mit höherer Genauigkeit ermittelt werden. Ferner werden Aliasingeffekte unterdrückt bzw.

zumindest reduziert.

Das Sensorelement kann insbesondere als auf kapazitiver Basis arbeitendes Sensorelement ausgebildet sein, beispielsweise als kapazitiver Lagegeber oder als kapazitiver Beschleunigungssensor.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:

FIG 1        eine Sensoreinrichtung und eine übergeordnete Einrichtung,
FIG 2        eine Sensoreinrichtung,
FIG 3        ein Ablaufdiagramm,
FIG 4 und 5  Zählerstände,
FIG 6        Zählerstände und ein Erregersignal,
FIG 7        Zählerstände und mehrere Erregersignale,
FIG 8        Zählerstände und
FIG 9        eine Sensoreinrichtung.

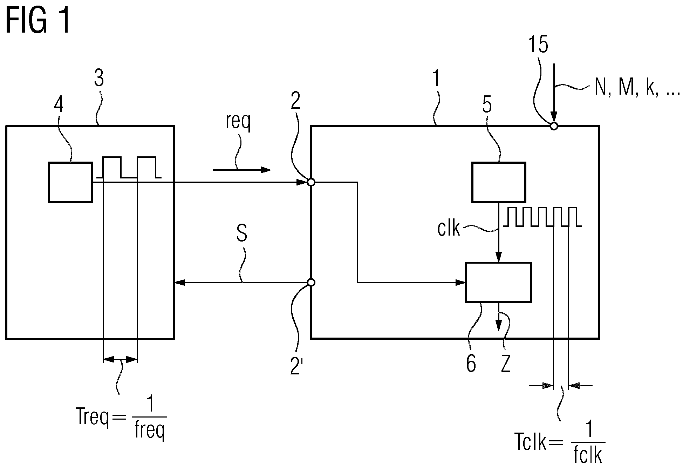

Gemäß FIG 1 weist eine Sensoreinrichtung 1 einen Signalanschluss 2 auf. Der Sensoreinrichtung 1 wird über den Signalanschluss 2 von einer übergeordneten Einrichtung 3 ein Abfragesignal req zugeführt. Das Abfragesignal req ist ein digitales Signal. Es weist entsprechend der Darstellung in FIG 1 alternierend ansteigende und abfallende Flanken auf. Die Zeitspanne zwischen je zwei unmittelbar aufeinanderfolgenden ansteigenden Flanken des Abfragesignals req wird nachfolgend als Abfrageperiode bezeichnet und mit dem Bezugszeichen Treq versehen.

Mit jeder ansteigenden Flanke fragt die übergeordnete Einrichtung 3 bei der Sensoreinrichtung 1 ein resultierendes Sensorsignal S ab. Die Sensoreinrichtung 1 gibt somit das resultierende Sensorsignal S in Reaktion auf das Zuführen des digitalen Abfragesignals req an die übergeordnete Einrichtung 3 aus. Das Ausgeben an die übergeordnete Einrichtung 3 kann - je nach Ausgestaltung der Kommunikation zwischen der Sensoreinrichtung 1 und der übergeordneten Einrichtung 3 - über den Signalanschluss 2 oder einen anderen Signalanschluss 2' der Sensoreinrichtung 1 erfolgen.

Alternativ zum Abfragen des Sensorsignals S bei jeder ansteigenden Flanke des digitalen Abfragesignals req könnte auch ein Abfragen des Sensorsignals S bei jeder abfallenden Flanke des digitalen Abfragesignals req erfolgen. In Ausnahmefällen ist es sogar möglich, dass ein Abfragen des Sensorsignals S sowohl bei jeder ansteigenden als auch bei jeder abfallenden Flanke des digitalen Abfragesignals req erfolgt. Nachfolgend wird entsprechend der üblichen Praxis davon ausgegangen, dass das Abfragen des Sensorsignals S bei jeder ansteigenden Flanke des digitalen Abfragesignals req erfolgt.

Das Abfragesignal req wird innerhalb der übergeordneten Einrichtung 3 mittels eines Taktgebers 4 generiert. Der Taktgeber 4 ist in der Regel quarzgesteuert und damit hochgenau. Eine Abfragefrequenz freq des Abfragesignals req - also der Wert 1/Treq - liegt meist im niedrigen oder mittleren Kilohertz-Bereich. Beispielsweise kann die Abfragefrequenz freq bei ca. 4 kHz, 8 kHz, 16 kHz oder 32 kHz liegen.

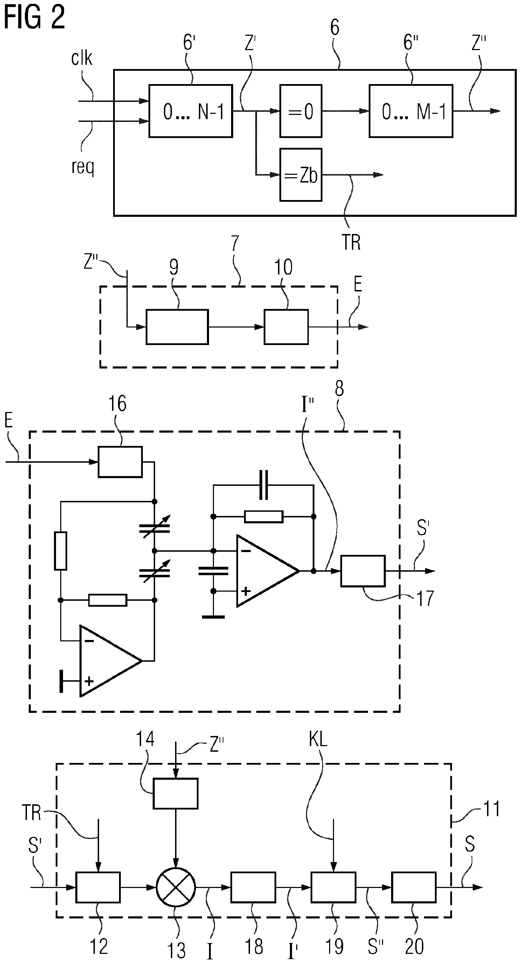

Die Sensoreinrichtung 1 weist - siehe ergänzend FIG 2 - ebenfalls einen Taktgeber auf, nachfolgend mit dem Bezugszeichen 5 bezeichnet. Der Taktgeber 5 gibt mit einer Basisfrequenz fclk ein Basissignal clk ab. Der Taktgeber 5 ist in der Regel ebenfalls quarzgesteuert und damit hochgenau. Das Basissignal clk ist ebenfalls ein digitales Signal. Es weist somit alternierend ansteigende und abfallende Flanken auf. Die Zeitspanne zwischen je zwei unmittelbar aufeinanderfolgenden ansteigenden Flanken des Basissignals clk wird nachfolgend als Basisperiode bezeichnet und mit dem Bezugszeichen Tclk versehen. Die Basisfrequenz fclk ist in aller Regel viel höher als die Abfragefrequenz freq. Beispielsweise kann die Basisfrequenz fclk bei 120 MHz liegen. Die zugehörige Basisperiode Tclk = 1/fclk liegt bei diesem Beispiel bei 8,33 ns.

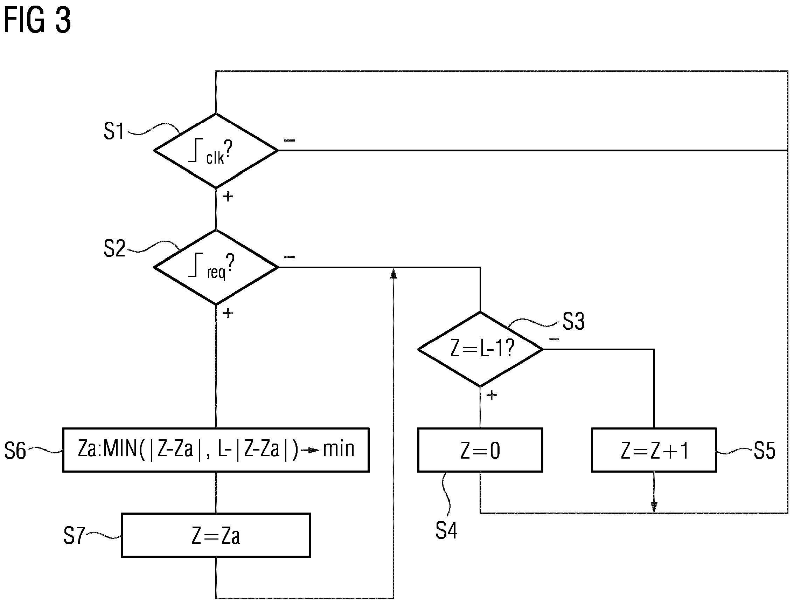

Die Sensoreinrichtung 1 weist weiterhin einen Zähler 6 auf. Dem Zähler 6 werden das Basissignal clk und das Abfragesignal req zugeführt. Der Zähler 6 gibt in Abhängigkeit von dem Basissignal clk und dem Abfragesignal req einen Zählerstand Z aus. Die Funktionsweise des Zählers 6 ist der wesentliche Gegenstand der vorliegenden Erfindung. Sie wird nachstehend in Verbindung mit FIG 3 näher erläutert.

Gemäß FIG 3 prüft der Zähler 6 in einem Schritt S1, ob seit der vorhergehenden Ausführung des Schrittes S1 eine ansteigende Flanke des Basissignals clk aufgetreten ist. Wenn dies nicht der Fall ist, geht der Zähler 6 zum Schritt S1 zurück. Wenn dies hingegen der Fall ist, geht der Zähler 6 zu einem Schritt S2 über.

Alternativ zum Prüfen des Basissignals clk auf das Auftreten einer ansteigenden Flanke könnte auch ein Prüfen auf das Auftreten einer abfallenden Flanke des Basissignals clk erfolgen. In Ausnahmefällen ist es sogar möglich, dass ein Prüfen des Basissignals clk sowohl auf das Auftreten einer ansteigenden als auch einer abfallenden Flanke erfolgt. Nachfolgend wird entsprechend der üblichen Praxis davon ausgegangen, dass das Prüfen des Basissignals clk auf das Auftreten einer ansteigenden Flanke erfolgt.

Wenn eine ansteigende Flanke des Basissignals clk aufgetreten ist, prüft der Zähler 6 im Schritt S2, ob seit der vorhergehenden Ausführung des Schrittes S2 eine ansteigende Flanke des Abfragesignals req aufgetreten ist. Wenn dies nicht der Fall ist, geht der Zähler 6 zu einem Schritt S3 über.

Im Schritt S3 prüft der Zähler 6, ob der Zählerstand Z einen Wert L-1 aufweist. Wenn dies der Fall ist, setzt der Zähler 6 in einem Schritt S4 den Zählerstand Z auf den Wert 0. Anderenfalls erhöht der Zähler 6 in einem Schritt S5 den Zählerstand Z um 1. Vom Schritt S4 bzw. S5 aus geht der Zähler 6 zum Schritt S1 zurück. Im Rahmen der wiederholten Ausführung der Schritte S1 bis S5 zählt der Zähler 6 den Zählerstand Z somit hoch. Das Hochzählen erfolgt jedoch modulo L. Der Zähler 6 zählt also von 0 auf 1, von 1 auf 2, von 2 auf 3 usw. bis von L-2 auf L-1. Nach L-1 kommt wieder 0. L ist somit ein Modulowert bzw. die Anzahl voneinander verschiedener Zählerstände Z. Der Modulowert L kann einen höheren zweistelligen, einen dreistelligen oder auch einen vierstelligen Wert aufweisen, beispielsweise den Wert 80, den Wert 400 oder den Wert 2000.

Wenn der Zähler 6 im Schritt S2 feststellt, dass seit der vorhergehenden Ausführung des Schrittes S2 eine ansteigende Flanke des Abfragesignals req aufgetreten ist, geht der Zähler 6 zu einem Schritt S6 über. Im Schritt S6 ermittelt der Zähler 6 denjenigen einer Anzahl von besonderen Zählerständen Za, bei dem der Abstand zum aktuellen Zählerstand Z minimal ist.

Beispielsweise kann der Zähler 6 die Anzahl von ansteigenden Flanken des Basissignals clk ermitteln, die erforderlich sind, um ausgehend von einem bestimmten besonderen Zählerstand Za zu dem aktuellen Zählerstand Z zu zählen. Im Rahmen dieser Ermittlung wird angenommen, dass keine ansteigende Flanke des Abfragesignals req auftritt. Weiterhin kann der Zähler 6 die Anzahl von ansteigenden Flanken des Basissignals clk ermitteln, die erforderlich sind, um ausgehend von dem aktuellen Zählerstand Z zu demselben bestimmten besonderen Zählerstand Za zu zählen. Auch im Rahmen dieser Ermittlung wird angenommen, dass keine ansteigende Flanke des Abfragesignals req auftritt. Der kleinere dieser beiden Werte entspricht dem Abstand dieses besonderen Zählerstandes Za vom aktuellen Zählerstand Z. Diese Vorgehensweise kann nun für alle besonderen Zählerstände Za vorgenommen werden. Dadurch kann auf einfache Weise der nächstliegende besondere Zählerstand Za bestimmt werden.

Sodann setzt der Zähler 6 in einem Schritt S7 den Zählerstand Z auf den im Schritt S6 ermittelten Wert, also auf den entsprechenden besonderen Zählerstand Z. Der Zählerstand Z wird somit im Ergebnis um den Abstand des Zählerstandes Z zum nächsten einer Anzahl von besonderen Zählerständen Za korrigiert. Vom Schritt S7 geht der Zähler 6 sodann zum Schritt S3 über.

Bei der Ermittlung des genannten Abstands ist die Zählung modulo L zu beachten. Wenn also - rein beispielsweise - der Modulowert L bei 2000 liegt und vier besondere Zählerstände Za definiert sind, die bei 100, 600, 1100 und 1600 liegen, und weiterhin der Zählerstand Z aktuell den Wert 1900 aufweist, so ist der nächstliegende besondere Zählerstand Za derjenige mit dem Wert 100. Denn dieser besondere Zählerstand Za weist einen Abstand von nur 200 zum aktuellen Zählerstand Z auf, während bei dem besonderen Zählerstand Za mit dem Wert 1600 der Abstand bei 300 liegt.

Im Rahmen der obenstehend in Verbindung mit FIG 3 erläuterten Vorgehensweise erfolgt das Korrigieren des Zählerstandes Z vor dem Hochzählen des Zählerstandes Z. Das Korrigieren des Zählerstandes Z könnte jedoch alternativ ebenso nach dem Hochzählen des Zählerstandes Z erfolgen. In diesem Fall würde zum einen auf den Schritt S1 direkt der Schritt S3 und danach einer der Schritte S4 und S5 folgen. Zum anderen müsste auf die Schritte S4 und S5 der Schritt S2 folgen, wobei im NEIN-Zweig des Schrittes S2 direkt und im JA-Zweig des Schrittes S2 nach der Ausführung der Schritte S6 und S7 zum Schritt S1 zurückgegangen wird.

Die obenstehend in Verbindung mit FIG 3 erläuterte Vorgehensweise ist nur dann sinnvoll, wenn die besonderen Zählerstände Za eine echte Teilmenge der möglichen Zählerstände Z sind, die Anzahl k an besonderen Zählerständen Za also kleiner als der Modulowert L ist. In aller Regel ist die Anzahl k an besonderen Zählerständen Za um mindestens eine Größenordnung (= Faktor 10) kleiner als der Modulowert L. Meist liegt die Anzahl k an besonderen Zählerständen Za im einstelligen oder niedrigen zweistelligen Bereich, beispielsweise bei 4 oder 8.

Eine günstige Festlegung für die Anzahl k an besonderen Zählerständen Za ist oftmals das kleinste gemeinsame Vielfache des Quotienten aus dem Produkt des Modulowerts L und der Basisperiode Tclk dividiert durch die Abfrageperiode einerseits und des Wertes 1 andererseits oder ein ganzzahliges Vielfaches dieses Wertes. Wenn also gilt k'

$$k' = kgV\ (LTclk/Treq,\ 1),$$

so ist die Anzahl k an besonderen Zählerständen Za entweder k' oder 2k' oder 3k' usw.

Aufgrund des Umstands, dass die Basisperiode Tclk erheblich kleiner als die Abfrageperiode Treq ist, wird der Zähler 6 somit im Regelfall mit der Basisfrequenz fclk modulo L hochgezählt. Eine Ausnahme stellt jedoch der Fall dar, dass gerade eine ansteigende Flanke des Abfragesignals req erfasst wurde. In diesem Fall wird vor oder nach dem Hochzählen des Zählerstandes Z der Zählerstand Z um den Abstand des Zählerstandes Z zum nächsten besonderen Zählerstand Za korrigiert.

In der Regel sind sowohl die Abfragefrequenz freq als auch die Basisfrequenz fclk durch einen jeweiligen Taktgeber 4, 5 bestimmt, der die jeweilige Frequenz freq, fclk sehr genau festlegt. Bei geeigneter Abstimmung des Modulowert des L und der besonderen Zählerstände Za auf die Frequenzen freq, fclk werden daher - außer bei der erstmaligen Korrektur zu Beginn - in der Regel nur geringfügige Korrekturen des Zählerstandes Z um kleine Werte erfolgen. In günstigen Fällen wird sogar ab und zu eine Korrektur des Zählerstandes Z um -1 oder +1 erfolgen. Falls eine Korrektur des Zählerstandes Z um mehr als 1 erforderlich ist, kann diese Korrektur alternativ sofort in ihrer Gesamtheit erfolgen oder auf mehrere Zählschritte des Zählerstandes Z verteilt werden. Die entsprechende Abwandlung des Ablaufdiagramms ist Fachleuten ohne weiteres möglich.

Die Funktionsweise des Zählers 6 wurde obenstehend in Form eines sequenziellen Ablaufs erläutert. In der Praxis ist der Zähler 6 jedoch oftmals als Hardwareschaltung ausgebildet. Seine Wirkungsweise wird in diesem Fall durch die verschiedenen Elemente des Zählers 6, so wie sie sind, festgelegt. Der Zähler 6 arbeitet in diesem Fall hingegen kein Softwareprogramm ab.

Die Sensoreinrichtung 1 weist weiterhin eine Erregereinrichtung 7 auf. Die Erregereinrichtung 7 gibt ein Erregersignal E an ein Sensorelement 8 der Sensoreinrichtung 1 aus. Das Erregersignal E kann beispielsweise eine elektrische Spannung oder ein elektrischer Strom sein. Der guten Ordnung halber sei an dieser Stelle erwähnt, dass der Begriff "Erregersignal" im generischen Sinne verwendet wird, so dass also von der Erregereinrichtung 7 gegebenenfalls auch mehrere Erregersignale E generiert werden können.

Der Zähler 6 kann der Erregereinrichtung 7 den jeweiligen Zählerstand Z als solchen zuführen. Die Erregereinrichtung 7 kann in diesem Fall anhand des jeweiligen Zählerstandes Z bestimmen, welchen Wert das Erregersignal E jeweils aufweist. Alternativ kann der Zähler 6 der Erregereinrichtung 7 anhand des Zählerstandes Z einen Wert ableiten und der Erregereinrichtung 7 den abgeleiteten Wert zuführen. In diesem Fall bestimmt die Erregereinrichtung 7 das Erregersignal E somit anhand des abgeleiteten Wertes.

Insbesondere kann der Zähler 6 intern einen ersten und einen zweiten Zähler 6', 6" aufweisen, nachfolgend als Subzähler bezeichnet. Die beiden Zähler 6', 6" weisen jeweils einen Zählerstand Z' von 0, 1, usw. bis N-1 bzw. einen Zählerstand Z" von 0, 1, usw. bis M-1 auf.

Der erste Subzähler 6' führt in diesem Fall mit jeder ansteigenden Flanke des Basissignals clk eine Zählung von 0 auf 1, weiter auf 2 usw. bis zu einem Wert N-1 und von dort wieder auf 0 durch. Der erste Subzähler 6' zählt also modulo N hoch. Eine Ausnahme gilt allerdings, wenn seit der vorhergehenden ansteigenden Flanke des Basissignals clk eine ansteigende Flanke des Abfragesignals req aufgetreten ist. In diesem Fall wird der Zählerstand Z' um den Abstand zum nächsten einer Anzahl von weiteren besonderen Zählerständen Za' korrigiert. Die besonderen Zählerstände Za' sind in diesem Fall eine echte Teilmenge der möglichen Zählerstände Z' des Subzählers 6'. Die Anzahl an besonderen Zählerständen Za' des erste Subzählers 6' kann gleich 1 oder größer als 1 sein. Die obigen Ausführungen zur Korrektur des Zählerstandes Z sind analog anwendbar. Für die auf den Zählerstand Z bezogenen besonderen Zählerstände Za gilt in diesem Fall

$$Za = mN + Za' \quad \text{mit } m = 0, 1, \text{ usw. bis } M\text{-}1$$

Jedes Mal, wenn der erste Subzähler 6' den Wert 0 annimmt, zählt der zweite Subzähler 6" um 1 hoch, also von 0 auf 1, weiter auf 2 usw. bis zu einem Wert M-1 und von dort wieder auf 0. Der zweite Subzähler 6" zählt also modulo M hoch.

Das Produkt der beiden natürlichen Zahlen N, M entspricht in diesem Fall dem Modulowert L. Der Zählerstand Z des Zählers 6 ergibt sich also zu Z' + NZ". Konkret führt der Zähler 6 entsprechend der Darstellung in FIG 2 der Erregereinrichtung 7 als abgeleiteten Wert den Zählerstand Z" zu.

In der Ausgestaltung gemäß FIG 2 ist das Ausgangssignal Z" des zweiten Subzählers 6" somit während jeweils N unmittelbar aufeinanderfolgenden Zählerständen Z konstant. An dieser Stelle bezieht sich die Aussage "unmittelbar aufeinanderfolgende Zählerstände Z" nicht auf die zeitliche Abfolge, sondern auf die Abfolge innerhalb der Sequenz möglicher Zählerstände Z. Da die Erregereinrichtung 7 das Erregersignal E in der Ausgestaltung gemäß FIG 2 anhand des Zählerstandes Z" des zweiten Subzählers 6" ermittelt, weist somit in der Ausgestaltung gemäß FIG 2 das Erregersignal E während jeweils N unmittelbar aufeinanderfolgender Zählerständen Z jeweils einen konstanten Wert auf. Der Wert kann sich nur ändern, wenn sich der Zählerstand Z" des zweiten Subzählers 6" ändert.

Der jeweilige Zählerstand Z (bzw. der daraus abgeleitete Wert) legt also eindeutig fest, welches Erregersignal E an das Sensorelement 8 ausgegeben wird. Entsprechend der konkreten Darstellung in FIG 2 wird in Abhängigkeit von dem Zählerstand Z" des zweiten Subzählers 6" einer ersten Lookup-Table 9 ein jeweiliger digitaler Wert entnommen, der über einen Digital-Analog-Wandler 10 in einen entsprechenden analogen Wert umgesetzt wird. Der analoge Wert wird dem Sensorelement 8 zugeführt.

Das Sensorelement 8 kann auf kapazitiver Basis arbeiten. Dies ist in der Darstellung in FIG 2 durch die Darstellung der veränderlichen Kapazitäten ersichtlich. Beispielsweise kann das Sensorelement 8 als kapazitiver Lagegeber oder als kapazitiver Beschleunigungssensor ausgebildet sein. Unabhängig davon, ob das Sensorelement 8 auf kapazitiver Basis arbeitet oder nicht, gibt das Sensorelement 8 jedoch aufgrund des Erregersignals E ein Rohsignal S' ab. Der guten Ordnung halber sei an dieser Stelle erwähnt, dass der Begriff "Rohsignal" im generischen Sinne verwendet wird, so dass also von dem Sensorelement 8 gegebenenfalls auch mehrere Rohsignale S' generiert werden können, beispielsweise bei einem Lagegeber ein Sinus- und ein Cosinussignal. Die in FIG 2 konkret dargestellte Schaltung des Sensorelements 8 ist weiterhin von untergeordneter Bedeutung. Sie kann also auch auf andere Art und Weise ausgestaltet sein.

Das Sensorelement 8 führt das Rohsignal S' einer Auswertungseinrichtung 11 zu, die ebenfalls Bestandteil der Sensoreinrichtung 1 ist. Der Auswertungseinrichtung 11 wird ebenfalls der jeweilige Zählerstand Z oder - wie in FIG 2 dargestellt - mindestens ein daraus abgeleiteter Wert zugeführt. Der abgeleitete Wert kann mit dem Wert identisch sein, welcher der Erregereinrichtung 7 zugeführt wird. Zwingend ist dies jedoch nicht erforderlich. Anhand des jeweiligen Zählerstandes Z oder des daraus abgeleiteten Wertes bestimmt die Auswertungseinrichtung 11, ob sie das Rohsignal S' erfasst und auf welche Art und Weise sie das jeweils erfasste Rohsignal S' der Ermittlung des resultierenden Sensorsignals S berücksichtigt.

Beispielsweise kann die Auswertungseinrichtung 11 entsprechend der konkreten Darstellung in FIG 2 das Rohsignal S' in einem Analog-Digital-Wandler 12 digitalisieren und sodann in einem Multiplizierer 13 mit einem Wichtungsfaktor multiplizieren. Das Produkt entspricht einem Zwischensignal I. Den Wichtungsfaktor kann die Auswertungseinrichtung 11 entsprechend der konkreten Darstellung in FIG 2 in Abhängigkeit von dem Zählerstand Z" einer zweiten Lookup-Table 14 entnehmen. Der jeweilige Zählerstand Z legt also eindeutig fest, wie ein jeweils erfasstes Rohsignal S' in die Ermittlung des resultierenden Sensorsignals S eingeht.

Der Zähler 6 gibt weiterhin bei bestimmten Zählerständen Zb jeweils ein Triggersignal TR an die Auswertungseinrichtung 11 aus. Immer dann, wenn der Zähler 6 ein Triggersignal TR ausgibt, gibt der Analog-Digital-Wandler 12 einen neuen Wert des Rohsignals S' aus. Der jeweilige Zählerstand Z legt also auch eindeutig fest, wann überhaupt und damit ob überhaupt ein Rohsignal S' erfasst wird.

In der Ausgestaltung gemäß FIG 2, bei welcher die beiden Subzähler 6', 6" verwendet werden, müssen die auf den Zählerstand Z' bezogenen besonderen Zählerstände Za' hinreichend weit von 0, N-1 und den bestimmten Zählerständen Zb entfernt liegen. Der Grund hierfür besteht darin, dass eine Korrektur des Zählerstandes Z bzw. des Zählerstandes Z' aufgrund einer ansteigenden Flanke des Abfragesignals req möglich sein soll, ohne zusätzliche Zählvorgänge des zweiten Zähler 6" auszulösen und ohne zusätzliche Triggersignale TR auszulösen.

Vorzugsweise wird das Triggersignal TR zusätzlich auch noch an die Erregereinrichtung 7 ausgegeben und triggert diese sowie die Auswertungseinheit 11 insgesamt, also nicht nur den darin enthaltenen Analog-Digital-Wandler 12, so dass die Erregereinrichtung 7 und die Auswertungseinheit 11 immer nur dann aktiv werden, wenn das Triggersignal TR ausgegeben wird. Zu den entsprechenden Zeitpunkten werden dann die jeweiligen Eingangssignale Z" bzw. S' und Z" ausgewertet, die beschriebenen Signalverarbeitungen abgearbeitet und die jeweiligen Ausgangssignale E bzw. S ausgegeben und bis zur nächsten Ausgabe auf Grund des nächsten Triggersignals TR beibehalten.

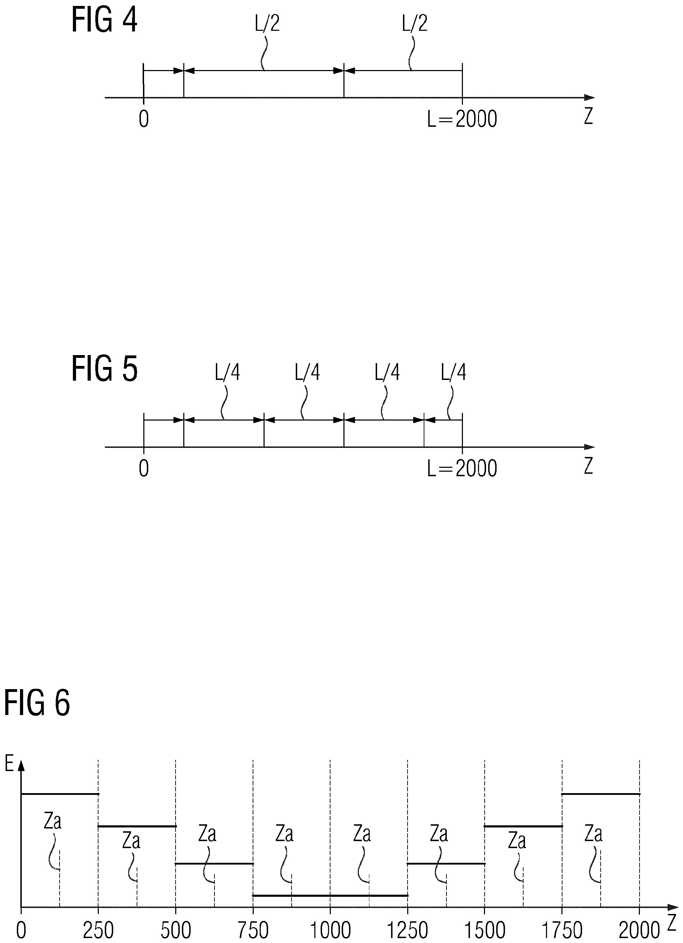

Die Anzahl k von besonderen Zählerständen Za kann 1 sein. Dies kann insbesondere dann sinnvoll sein, wenn der Quotient der Abfrageperiode Treq und der Basisperiode Tclk hinreichend genau gleich einem ganzzahligen Vielfachen der Anzahl L an möglichen Zählerständen Z ist, wenn also mit hinreichender Genauigkeit Treq/Tclk = lL gilt, wobei l eine natürliche Zahl ist. Die Anzahl k von besonderen Zählerständen Za kann aber ebenso auch größer als 1 sein. Dies kann insbesondere dann sinnvoll sein, wenn der Quotient der Abfrageperiode Treq und der Basisperiode Tclk nicht hinreichend genau gleich einem ganzzahligen Vielfachen der Anzahl L an möglichen Zählerständen Z ist. In diesem Fall sind die besonderen Zählerstände Za in der Regel möglichst gleichmäßig über die möglichen Zählerstände Z verteilt. Bei k besonderen Zählerständen Za weisen die besonderen Zählerstände Za also nach Möglichkeit einen Abstand von L/k voneinander auf. Geringfügige Abweichungen sind aber unkritisch. Beispielsweise bei einem Modulowert L von 2000 und einer Anzahl k von besonderen Zählerständen Za von beispielsweise 2 (siehe FIG 4) oder 4 (siehe FIG 5) weisen die besonderen Zählerstände Za also entsprechend der Darstellung in den FIG 4 und 5 vorzugsweise einen Abstand von 2000/2 = 1000 (oder von 2000/4 = 500) bzw. allgemein von L/2 bzw. L/4 voneinander auf.

Wie bereits erwähnt, ändert sich das Erregersignal E innerhalb eines jeweiligen Abschnitts von N unmittelbar aufeinanderfolgenden Zählerständen Z nicht. Die zugehörige Anzahl M von Abschnitten ist L/N. Vorzugsweise ist die Anzahl M an Abschnitten ein ganzzahliges Vielfaches der Anzahl k an besonderen Zählerständen Za. Vorzugsweise gilt also M = mk, wobei m eine natürliche Zahl ist. Wenn also beispielsweise die Anzahl M an Abschnitten 8 beträgt, so ist die Anzahl k an besonderen Zählerständen Za vorzugsweise 1, 2, 4 oder 8. Weiterhin liegen die besonderen Zählerstände Za vorzugsweise in etwa in der Mitte des jeweiligen Abschnitts. Dies ist in FIG 6 dargestellt.

Wenn also beispielsweise der Modulowert L den Wert 2000 aufweist und das Erregersignal E für Zählerstände Z von 0 bis 249, von 250 bis 499, von 500 bis 749 usw. jeweils einen konstanten Wert aufweist, so sollten bei 8 besonderen Zählerständen Za die besonderen Zählerstände Za bei etwa 125, 375, 625 usw. liegen. Bei vier besonderen Zählerständen Za entfällt jeder zweite der acht genannten Zählerstände Za. Beispielsweise können die verbleibenden besonderen Zählerstände Za dann bei 125, 625, 1125 und 1625 liegen. Bei zwei besonderen Zählerständen Za entfallen je drei aufeinanderfolgende der acht genannten Zählerstände Za. Beispielsweise können die verbleibenden besonderen Zählerstände Za dann bei 125 und 1125 liegen.

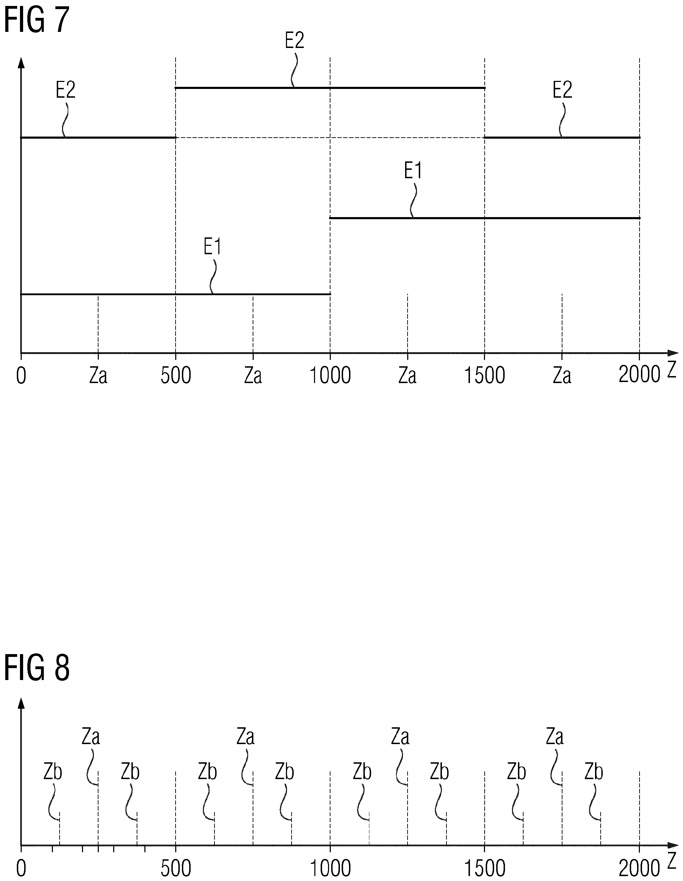

Wie bereits erwähnt, ist es möglich, dass die Erregereinrichtung 7 mehrere Erregersignale E abgibt. In diesem Fall ist jedes der abgegebenen Erregersignale E im jeweiligen Abschnitt konstant. In diesem Fall sind die Abschnitte also derart definiert, dass sich innerhalb des jeweiligen Abschnitts keines der Erregersignale E ändert. Dies wird nachstehend in Verbindung mit FIG 7 für den Fall von zwei Erregersignalen - nachfolgend mit E1 und E2 bezeichnet - näher erläutert. Das Prinzip ist aber ohne weiteres auch auf noch mehr Erregersignale E erweiterbar.

Wenn beispielsweise der Modulowert L den Wert 2000 aufweist, das eine Erregersignal E1 für Zählerstände Z von 0 bis 999 einen ersten Wert und für Zählerstände Z von 1000 bis 1999 einen zweiten Wert aufweist und weiterhin das andere Erregersignal E2 für Zählerstände Z von 500 bis 1499 einen dritten Wert und für Zählerstände Z von 1500 bis 1999 und von 0 bis 499 einen vierten Wert aufweist, so werden insgesamt vier Abschnitte gebildet, nämlich von 0 bis 499, von 500 bis 999, von 1000 bis 1499 und von 1500 bis 1999. Hiermit können dann beispielsweise auch 1, 2 oder 4 besondere Zählerstände Za definiert werden, die im Falle von 4 besonderen Zählerständen Za vorzugsweise bei etwa 250, 750, 1250 und 1750 liegen.

Falls im Einzelfall eine Korrektur des Zählerstandes Z um mehr als 1 erforderlich ist (vergleiche den Schritt S7 in FIG 2) und diese Korrektur auf mehrere Zählschritte des Zählerstandes Z verteilt wird, kann die Korrektur weiterhin insbesondere auf die Abschnitte verteilt werden, beispielsweise in jedem der Abschnitte jeweils eine Korrektur um +1 oder -1 erfolgen, bis die Korrektur abgeschlossen ist.

Aus FIG 6 ist auch ersichtlich, dass das Erregersignal E, bezogen auf die Abfolge der Zählerstände Z, mit dem Modulowert L periodisch ist. Es kann, bezogen auf die Abfolge der Zählerstände Z, mit der (sinusförmigen) Grundschwingung oszillieren. Alternativ kann es sich um ein rechteckiges Signal mit einem Tastverhältnis plus zu minus von 1:1 handeln. Es sind auch andere Signalverläufe möglich. In jedem Fall sollte die (sinusförmige) Grundschwingung (oder eine höhere Harmonische) jedoch den dominanten Anteil des Erregersignals E bestimmen.

Die genannten Sachverhalte sind auch für den Fall gültig, dass die Erregereinrichtung 7 mehrere Erregersignale E1, E2 abgibt. In diesem Fall gelten die genannten Ausführungen für jedes einzelne Erregersignal E1, E2. Beispielsweise können entsprechend der Darstellung in FIG 7 die beiden Erregersignale E1, E2 jeweils rechteckige Signale mit einem Tastverhältnis plus zu minus von 1:1 sein.

Wie bereits erwähnt, erfasst der Analog-Digital-Wandler 12 (und damit auch die Auswertungseinrichtung 11 insgesamt) das Rohsignal S' ausschließlich dann, wenn ihr der Zähler 6 ein Triggersignal TR übermittelt, wobei der Zähler 6 das Triggersignal TR nur bei bestimmten Zählerständen Zb ausgibt. Nur bei den bestimmten Zählerständen Zb wird also das Rohsignal S' erfasst. Die bestimmten Zählerstände Zb sind vorzugsweise von den Grenzen der aufeinanderfolgenden Abschnitte entfernt. Wenn beispielsweise entsprechend der Darstellung in FIG 8 bei einem Modulowert L von 2000 sich insgesamt vier Abschnitte über jeweils 500 aufeinanderfolgende Zählerstände Z erstrecken, beispielsweise von 0 bis 499 usw., so sind die bestimmten Zählerstände Zb hinreichend von den Grenzen der Abschnitte entfernt, also hinreichend verschieden von 499 bzw. 500, von 999 bzw. 1000, von 1499 bzw. 1500 und von 1999 bzw. 0. Weiterhin sind die bestimmten Zählerstände Zb, wie ebenfalls bereits erwähnt, hinreichend von den besonderen Zählerständen set a verschieden. Beispielsweise können die bestimmten Zählerstände Zb um mindestens 50 oder um mindestens 100 von den Grenzen der Abschnitte und von den besonderen Zählerständen Za entfernt sein. Durch diese Vorgehensweise kann insbesondere vermieden werden, dass eine Erfassung des Rohsignals in der Nähe des transienten Zustands beim Ändern des Erregersignals vorgenommen wird. Dies kann insbesondere aus EMV-Gründen von Vorteil sein. Wenn sich beispielsweise ein Abschnitt von 0 bis 499 erstreckt und bei 250 ein besonderer Zählerstand Za liegt, sollte im Bereich zwischen 200 und 300 kein bestimmter Zählerstand Zb liegen. In diesem Fall kann der entsprechende bestimmte Zählerstand Zb beispielsweise bei etwa 125 und/oder bei etwa 375 liegen. Die genannten Zahlenwerte sind selbstverständlich nur rein beispielhaft.

In manchen Fällen kann es sinnvoll sein, das Rohsignal S' in einem bestimmten Abschnitt überhaupt nicht zu erfassen. In der Regel wird das Rohsignal S' jedoch pro Abschnitt mindestens je einmal erfasst. Es kann aber auch mehrmals erfasst werden. In beiden Fällen ist Anzahl an bestimmten Zählerständen Zb ein ganzzahliges Vielfaches der Anzahl M an Abschnitten.

Falls das Rohsignal S' pro Abschnitt mehrmals erfasst wird, kann es insbesondere sinnvoll sein, das Rohsignal S' pro Abschnitt zweimal zu erfassen. In diesem Fall kann es weiterhin sinnvoll sein, das Rohsignal S' je einmal in etwa in der Mitte zwischen dem jeweiligen besonderen Zählerstand Za des jeweiligen Abschnitts und den beiden Grenzen des jeweiligen Abschnitts zu erfassen. Wenn also beispielsweise sich ein Abschnitt von 0 bis 499 erstreckt und der besondere Zählerstand Za etwa 250 ist, so sollte eine Erfassung des Rohsignals S' bei Zählerständen Z von etwa 125 und etwa 375 erfolgen.

Es ist möglich, dass alle Betriebsparameter der Sensoreinrichtung 1 bereits bei der Herstellung der Sensoreinrichtung 1 festgelegt werden. Alternativ ist es möglich, dass die Sensoreinrichtung 1 entsprechend der Darstellung in FIG 1 einen Parametriereingang 15 aufweist, über den der Sensoreinrichtung 1 nach deren Herstellung verschiedene Parameter vorgebbar sind. Das Vorgeben der Parameter kann insbesondere bei der Inbetriebnahme der Sensoreinrichtung 1 erfolgen. Beispielsweise können der Sensoreinrichtung 1 über den Parametriereingang 15 die Länge der Abschnitte und deren Anzahl vorgegeben werden, im Ergebnis also die Zahlen N und M. Alternativ oder zusätzlich kann der Sensoreinrichtung 1 über den Parametriereingang 15 die Anzahl k an besonderen Zählerständen Za vorgegeben werden.

Alternativ oder zusätzlich kann der Sensoreinrichtung 1 über den Parametriereingang 15 mindestens ein Betriebsparameter der Erregereinrichtung 7 vorgegeben werden. Bei diesen Betriebsparametern kann es sich insbesondere um die von der Erregereinrichtung 7 abzugebenden Werte des Erregersignals E handeln. Diese Werte können beispielsweise in der Lookup-Table 9 hinterlegt werden.

Alternativ oder zusätzlich kann der Sensoreinrichtung 1 über den Parametriereingang 15 mindestens ein Betriebsparameter des Sensorelements 8 vorgegeben werden. Beispielsweise kann das Sensorelement 8 entsprechend der Darstellung in FIG 2 eingangsseitig und/oder ausgangsseitig ein Tiefpassfilter 16, 17 aufweisen. Mittels des eingangsseitigen Tiefpassfilters 16 kann das Erregersignal E gefiltert werden. Mittels des ausgangsseitigen Tiefpassfilters 17 kann ein Vorsignal I'' gefiltert werden, das anhand des (gegebenenfalls bereits gefilterten) Erregersignals E generiert wird. Sowohl das eingangsseitige als auch das ausgangsseitige Tiefpassfilter 16, 17 des Sensorelements 8 sind analoge Filter. Mittels der Parameter für das Sensorelement 8 können beispielsweise Filterparameter des eingangsseitigen und/oder des ausgangsseitigen Tiefpassfilters 16, 17 eingestellt werden.

Der wesentliche Unterschied zwischen dem eingangsseitigen und dem ausgangsseitigen Tiefpassfilter 16, 17 ist, dass das eingangsseitige Tiefpassfilter 16 auf ein Signal wirkt, das durch ein mechanisch bewegbares Element des Sensorelements 8 noch nicht beeinflusst ist, während das ausgangsseitige Tiefpassfilter 10 auf ein Signal wirkt, das bereits durch das mechanisch bewegbare Element des Sensorelements 8 beeinflusst ist. Das von dem eingangsseitigen Tiefpassfilter 16 gefilterte Signal enthält also noch nicht die Information über den Zustand des Sensorelements 8, das von dem ausgangsseitigen Tiefpassfilter 17 gefilterte Signal hingegen enthält diese Information. Das im ausgangsseitigen Tiefpassfilter 17 gefilterte Vorsignal ist das vom Sensorelement 8 generierte Rohsignal S'.

Alternativ oder zusätzlich kann der Sensoreinrichtung 1 über den Parametriereingang 15 mindestens ein Betriebsparameter der Auswertungseinrichtung 11 vorgegeben werden. Dies wird nachstehend näher erläutert.

Bei den Betriebsparametern für die Auswertungseinrichtung 11 kann es sich beispielsweise um zu den Werten des Erregersignals E korrespondierende Auswertungsfaktoren handeln, also um die dem Multiplizierer 13 zugeführten Werte. Diese Werte können beispielsweise in der Lookup-Table 14 hinterlegt werden. Diese Werte legen - zusammen mit den Parametern eines nachfolgenden Tiefpassfilters 18, mittels dessen die Zwischensignale I gefiltert werden - beispielsweise fest, auf welche Art und Weise das Rohsignal S' weiterverarbeitet wird, beispielsweise ob es einer Fouriertransformation unterzogen wird. Insbesondere ist es beispielsweise für das Durchführen einer Fouriertransformation erforderlich, dass die Lookup-Table 14 geeignete cosinusförmig verlaufende Werte enthält und das Tiefpassfilter 18 eine Mitteilung über eine Periode des Erregersignals E vornimmt. Das Tiefpassfilter 18 ist in der Regel ein digitales Filter. Das Ausgangssignal des Tiefpassfilters 18 wird nachfolgend als weiteres Zwischensignal bezeichnet und hierfür das Bezugszeichen I' verwendet. Auch die Parameterwerte des Tiefpassfilters 18 können Betriebsparameter für die Auswertungseinrichtung 11 sein, die der Sensoreinrichtung 1 vorgegeben werden.

Durch Auswertung der weiteren Zwischensignale I' in einem Auswertungselement 19 kann sodann ein Signal ermittelt werden, das von seiner Art her mit dem resultierenden Sensorsignal S korrespondiert. Die Auswertung in dem Auswertungselement 19 erfolgt oftmals mittels einer nichtlinearen Auswertungskennlinie KL. Das Auswertungselement 19 kann beispielsweise als Lookup-Table ausgebildet sein. Bei den Betriebsparametern für die Auswertungseinrichtung 11 kann es sich um die Auswertungskennlinie KL der Auswertungseinrichtung 11 handeln. Das Signal, das von seiner Art her mit dem resultierenden Sensorsignal S korrespondiert, wird nachstehend als vorläufiges Sensorsignal S'' bezeichnet.

Schließlich kann dem Auswertungselement 19 ein weiteres Tiefpassfilter 20 nachgeordnet sein. Das Tiefpassfilter 20 ist ebenfalls als digitales Filter ausgebildet. Es kann beispielsweise über eine vorbestimmte Anzahl von aufeinanderfolgenden, aneinander anschließenden, sich aber nicht überlappenden Perioden des Erregersignals E - das kann im Einzelfall eine einzelne Periode sein, wird im Regelfall aber eine Mehrzahl von Perioden sein - das resultierende Sensorsignal S als Mittelwert der für die Perioden des Erregersignals E ermittelten vorläufigen Sensorsignale S'' ermitteln. Da pro Periode eine bestimmte Anzahl von Signalfassungen erfolgt, wird damit auch die gleiche Anzahl vorläufiger Sensorsignale S'' ermittelt. Wenn diese Anzahl mit k'' bezeichnet wird, wird für die genannte Mittelung demzufolge nur jedes k''-te vorläufige Sensorsignal S'' verwertet. Sofern weiterhin Treq/(LTclk) ganzzahlig ist und die Anzahl an Werten, über welche in dem Tiefpassfilter 20 gemittelt wird, gleich Treq/(LTclk) ist, wird damit letztlich über eine Abfrageperiode Treq gemittelt. Das ist insbesondere oft dann vorteilhaft, wenn es sich bei dem Sensorelement 8 um einen Beschleunigungssensor handelt. In diesem Fall sind die vorläufigen Sensorsignale S'' nämlich proportional der über eine Periode des Erregersignals E gemittelten zu messenden Beschleunigung, und die beschriebene Mittelung ergibt einen Wert, der proportional zu der über eine (1) Abfrageperiode Treq gemittelten Beschleunigung ist. Eine solchermaßen gemittelte Beschleunigung ist oft vorteilhaft gegenüber einem Beschleunigungsmomentanwert, weil die Aufsummation solchermaßen gemittelter Beschleunigungswerte der Geschwindigkeit entspricht und weiterhin Aliasing-Effekte unterdrückt werden.

Für alle Möglichkeiten der Parametrierung gilt, dass auch äquivalente Vorgaben möglich sind. Beispielsweise ist es möglich, anstelle der ersten und der zweiten ganzen Zahl N, M eine dieser beiden Zahlen N, M und das Produkt L der beiden Zahlen N, M vorzugeben. Ähnliche Ausführungen gelten für die anderen möglichen Parameter.

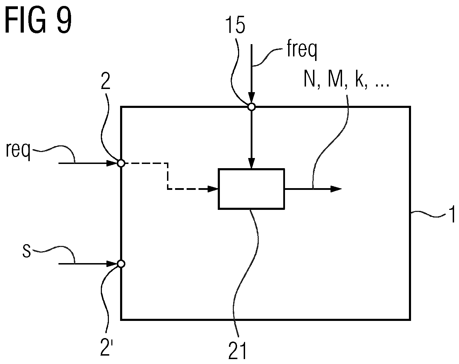

FIG 9 zeigt eine weitere Sensoreinrichtung 1. Die Sensoreinrichtung 1 ist in FIG 9 stark vergröbert dargestellt. Die Funktionsweise ist so, wie obenstehend in Verbindung mit insbesondere FIG 2 und 3 erläutert Im Unterschied zur Sensoreinrichtung 1 von FIG 1 weist die Sensoreinrichtung 1 von FIG 9 eine Parameterbestimmungseinrichtung 21 auf. Die Parameterbestimmungseinrichtung 21 ermittelt anhand der Abfragefrequenz freq selbsttätig mindestens einen Betriebsparameter der Sensoreinrichtung 1. Es kann sich hierbei um einen beliebigen (oder auch mehrere beliebige) der Betriebsparameter handeln, die obenstehend in Verbindung mit der Vorgabe über den Parametriereingang 15 der Sensoreinrichtung 1 von FIG 1 erläutert wurden.

Es ist möglich, dass die Sensoreinrichtung entsprechend der Darstellung in FIG 9 zusätzlich zur Parameterbestimmungseinrichtung 21 den Parametriereingang 15 aufweist. In diesem Fall ist zum einen eine "gemischte" Vorgehensweise möglich, dass also mindestens einer der Betriebsparameter direkt über den Parametriereingang 15 vorgegeben wird, während mindestens ein anderer der Betriebsparameter von der Parameterbestimmungseinrichtung 21 anhand der Abfragefrequenz freq ermittelt wird. Zum anderen ist es möglich, der Parameterbestimmungseinrichtung 21 über den Parametriereingang 15 direkt die Abfragefrequenz freq als solche vorzugeben. Die Vorgabe der Abfragefrequenz freq erfolgt in diesem Fall nach der Herstellung der Sensoreinrichtung 1, insbesondere bei der Inbetriebnahme der Sensoreinrichtung 1. Alternativ zu einer direkten Vorgabe der Abfragefrequenz freq ist es möglich, dass die Parameterbestimmungseinrichtung 21 mit dem Signalanschluss 2 verbunden ist und anhand des Abfragesignals req die Abfragefrequenz freq selbsttätig ermittelt. Dies ist in FIG 9 gestrichelt angedeutet.

Wie obenstehend in Verbindung mit der Parametrierbarkeit der Auswertungseinrichtung 11 erläutert, ist es möglich, dass die Auswertungseinrichtung 11 zunächst für jeweils eine Periode des Erregersignals E ein zugehöriges vorläufiges Sensorsignal S" ermittelt und sodann für eine Mehrzahl derartiger Perioden das resultierende Sensorsignal S als Mittelwert der vorläufigen Sensorsignale S" ermittelt. Eine hierzu gleichwertige Formulierung ist, dass die Auswertungseinrichtung 11 für jeweils eine Anzahl von Zählerständen Z ein vorläufiges Sensorsignal S" ermittelt, wobei die soeben genannte Anzahl von Zählerständen Z gleich dem Modulowert L ist. Weiterhin wurde obenstehend erläutert, dass die Auswertungseinrichtung 11 - konkret mittels des Analog-Digital-Wandlers 12 und des Auswertungselements 19 - zunächst anhand der Rohsignale S' ein Zwischensignal I, I' ermittelt und anhand des jeweiligen Zwischensignals I, I' unter Verwertung einer nichtlinearen Kennlinie KL ein jeweiliges vorläufiges Sensorsignal S" ermittelt. Vorzugsweise erfolgt die letztgenannte Mittelwertbildung - also die Ermittlung des resultierenden Sensorsignal S als Mittelwert der vorläufigen Sensorsignale S" - ab dem zuletzt abgefragten resultierenden Sensorsignal S. Die Mittelwertbildung kann insbesondere in dem Tiefpassfilter 20 erfolgen.

Zusammengefasst betrifft die vorliegende Erfindung somit folgenden Sachverhalt:

Eine Sensoreinrichtung 1 weist einen Taktgeber 5, einen Zähler 6, eine Erregereinrichtung 7, ein Sensorelement 8 und eine Auswertungseinrichtung 11 auf. Der Sensoreinrichtung 1 wird über einen Signalanschluss 2 ein digitales Abfragesignal req zugeführt, das alternierend ansteigende und abfallende Flanken aufweist. In Reaktion darauf gibt die Sensoreinrichtung 1 ein Sensorsignal S aus. Der Taktgeber 5 gibt mit einer Basisfrequenz fclk ein digitales Basissignal clk ab, das alternierend ansteigende und abfallende Flanken aufweist. Der Zähler 6 zählt einen Zählerstand Z modulo eines Modulowertes L hoch, sofern zwischen zwei ansteigenden und/oder abfallenden Flanken des Basissignals clk keine ansteigende und/oder abfallende Flanke des Abfragesignals req auftritt. Tritt hingegen eine derartige Flanke des Abfragesignals req auf, korrigiert der Zähler 6 den Zählerstand Z um den Abstand zum nächsten einer Anzahl von besonderen Zählerständen Za. Die Erregereinrichtung 7 gibt ein Erregersignal E an das Sensorelement 8 aus. Der Wert des Erregersignals E wird von der Erregereinrichtung 7 anhand des jeweiligen Zählerstandes Z oder eines daraus abgeleiteten Wertes bestimmt. Das Sensorelement 8 gibt aufgrund des Erregersignals E ein Rohsignal S' ab, das der Auswertungseinrichtung 11 zugeführt wird. Die Auswertungseinrichtung 11 bestimmt anhand des jeweiligen Zählerstandes Z oder eines daraus abgeleiteten Wertes, ob sie das Rohsignal S' erfasst und auf welche Art und Weise sie das jeweils erfasste Rohsignal S' bei der Ermittlung des Sensorsignals S berücksichtigt.

Die vorliegende Erfindung weist viele Vorteile auf. Insbesondere kann die Totzeit nahezu perfekt konstant gehalten werden. Die Sensoreinrichtung 1 ist sehr einfach ausgebildet. Eine analog arbeitende phasenverriegelte Schleife (PLL = phase locked loop) ist nicht erforderlich.

Der Schutzumfang der Erfindung ist durch den Gegenstand der angefügten Ansprüche definiert.

**Patentansprüche**

**1.** Sensoreinrichtung,

- wobei die Sensoreinrichtung einen Signalanschluss (2) aufweist, über den der Sensoreinrichtung von einer übergeordneten Einrichtung (3) ein digitales Abfragesignal (req) zuführbar ist, so dass das Abfragesignal (req) alternierend ansteigende und abfallende Flanken aufweist,

- wobei die Sensoreinrichtung dazu eingerichtet ist, Z in Reaktion auf das Zuführen des digitalen Abfragesignals (req) über den Signalanschluss (2) oder einen anderen Signalanschluss (2') ein resultierendes Sensorsignal (S) an die übergeordnete Einrichtung (3) auszugeben,

- wobei die Sensoreinrichtung einen Taktgeber (5) aufweist, der dazu eingerichtet ist, mit einer Basisfrequenz (fclk) ein digitales Basissignal (clk) abzugeben, so dass das Basissignal (clk) alternierend ansteigende und abfallende Flanken aufweist,

- wobei die Sensoreinrichtung einen Zähler (6) aufweist, dem das Basissignal (clk) und das Abfragesignal (req) zugeführt werden und der dazu eingerichtet ist, einen Zählerstand (Z) auszugeben,

- wobei der Zähler (6) dazu eingerichtet ist, sofern zwischen zwei unmittelbar aufeinanderfolgenden ansteigenden und/oder abfallenden Flanken des Basissignals (clk) keine ansteigende und/oder abfallende Flanke des Abfragesignals (req) auftritt, den Zählerstand (Z) modulo eines Modulowertes (L) hochzuzählen,

- wobei der Zähler (6) dazu eingerichtet ist, sofern zwischen zwei unmittelbar aufeinanderfolgenden ansteigenden und/oder abfallenden Flanken des Basissignals (clk) eine ansteigende und/oder abfallende Flanke des Abfragesignals (req) auftritt, vor oder nach dem Hochzählen des Zählerstandes (Z) den Zählerstand (Z) um den Abstand des Zählerstandes (Z) zum nächsten einer Anzahl von besonderen Zählerständen (Za) zu korrigieren,

- wobei die besonderen Zählerstände (Za) eine echte Teilmenge der möglichen Zählerstände (Z) sind,

- wobei die Sensoreinrichtung eine Erregereinrichtung (7) aufweist, welche dazu eingerichtet ist, ein Erregersignal (E) an ein Sensorelement (8) der Sensoreinrichtung auszugeben,

- wobei der jeweilige Zählerstand (Z) oder ein daraus abgeleiteter Wert der Erregereinrichtung (7) zugeführt wird und die Erregereinrichtung (7) dazu eingerichtet ist, anhand des jeweiligen Zählerstandes (Z) oder des daraus abgeleiteten Wertes zu bestimmen, welchen Wert das Erregersignal (E) jeweils aufweist,

- wobei das Sensorelement (8) dazu eingerichtet ist, aufgrund des Erregersignals (E) ein Rohsignal (S') abzugeben,

- wobei die Sensoreinrichtung eine Auswertungseinrichtung (11) aufweist, der das Rohsignal (S') zugeführt wird,

- wobei der jeweilige Zählerstand (Z) oder ein daraus abgeleiteter Wert der Auswertungseinrichtung (11) zugeführt wird und die Auswertungseinrichtung (11) dazu eingerichtet ist, anhand des jeweiligen Zählerstandes (Z) oder des daraus abgeleiteten Wertes zu bestimmen, ob sie das Rohsignal (S') erfasst und auf welche Art und Weise sie das jeweils erfasste Rohsignal (S') bei der Ermittlung des resultierenden Sensorsignals (S) berücksichtigt.

2. Sensoreinrichtung nach Anspruch 1, **dadurch gekennzeichnet, dass** die Anzahl (k) von besonderen Zählerständen (Za) 1 ist.

3. Sensoreinrichtung nach Anspruch 1, **dadurch gekennzeichnet, dass** die Anzahl (k) von besonderen Zählerständen (Za) größer als 1 ist.

4. Sensoreinrichtung nach Anspruch 1, 2 oder 3, **dadurch gekennzeichnet,**

- **dass** das von der Erregereinrichtung (7) an das Sensorelement (8) abgegebene Erregersignal (E), bezogen auf die Abfolge der Zählerstände (Z), während aufeinanderfolgender, in sich zusammenhängender Abschnitte von Zählerständen (Z) jeweils einen konstanten Wert aufweist,
- **dass** die Abschnitte von Zählerständen (Z) jeweils zumindest in etwa die gleiche Anzahl (N) an Zählerständen (Z) umfassen,
- **dass** die Anzahl (M) an Abschnitten ein ganzzahliges Vielfaches der Anzahl (k) an besonderen Zählerständen (Za) ist, insbesondere gleich der Anzahl (k) an besonderen Zählerständen (Za) ist, und
- **dass** die besonderen Zählerstände (Za) in etwa in der Mitte des jeweiligen Abschnitts liegen.

5. Sensoreinrichtung nach Anspruch 4,
**dadurch gekennzeichnet,**
**dass** die Auswertungseinrichtung (11) das Rohsignal (S') ausschließlich bei bestimmten Zählerständen (Zb) erfasst.

6. Sensoreinrichtung nach Anspruch 5,
**dadurch gekennzeichnet,**
**dass** die bestimmten Zählerstände (Zb) von den Grenzen der aufeinanderfolgenden Abschnitte entfernt sind.

7. Sensoreinrichtung nach Anspruch 4, 5 oder 6,
**dadurch gekennzeichnet,**

- **dass** der Modulowert (L) gleich dem Produkt einer ersten und einer zweiten ganzen Zahl (N, M) ist,
- **dass** die erste ganze Zahl (N) gleich der Anzahl (N) an aufeinanderfolgenden Zählerständen (Z) ist, während derer das Erregersignal (E) jeweils einen konstanten Wert aufweist,
- **dass** die zweite ganze Zahl (M) gleich der Anzahl (M) an Abschnitten aufeinanderfolgender Zählerstände (Z) ist, während derer das Erregersignal (E) jeweils einen konstanten Wert aufweist, und
- **dass** die Sensoreinrichtung einen Parametriereingang (15) aufweist, über den der Sensoreinrichtung nach der Herstellung der Sensoreinrichtung, insbesondere bei der Inbetriebnahme der Sensoreinrichtung, die erste und die zweite ganze Zahl (N, M) vorgebbar sind.

8. Sensoreinrichtung nach einem der obigen Ansprüche,
**dadurch gekennzeichnet,**
**dass** die Sensoreinrichtung einen Parametriereingang (15) aufweist, über den der Sensoreinrichtung nach der Herstellung der Sensoreinrichtung, insbesondere bei der Inbetriebnahme der Sensoreinrichtung, die Anzahl (k) an besonderen Zählerständen (Za) vorgebbar ist.

9. Sensoreinrichtung nach einem der obigen Ansprüche,
**dadurch gekennzeichnet,**
**dass** die Sensoreinrichtung einen Parametriereingang (15) aufweist, über den der Sensoreinrichtung nach der Herstellung der Sensoreinrichtung, insbesondere bei der Inbetriebnahme der Sensoreinrichtung, mindestens ein Betriebsparameter der Erregereinrichtung (7) und/oder des Sensorelements (8) und/oder der Auswertungseinrichtung (11) vorgebbar ist.

10. Sensoreinrichtung nach einem der obigen Ansprüche,
**dadurch gekennzeichnet,**
**dass** die Sensoreinrichtung eine Parameterbestimmungseinrichtung (21) aufweist, mittels derer die Sensoreinrichtung anhand der Abfragefrequenz (freq) mindestens einen Betriebsparameter der Sensoreinrichtung selbsttätig ermittelt.

11. Sensoreinrichtung nach Anspruch 10,
**dadurch gekennzeichnet,**
**dass** die Sensoreinrichtung einen Parametriereingang (15) aufweist, über den der Sensoreinrichtung nach der Herstellung der Sensoreinrichtung, insbesondere bei der Inbetriebnahme der Sensoreinrichtung, die Abfragefrequenz (freq) als solche vorgebbar ist, oder dass das Abfragesignal (req) innerhalb der Sensoreinrichtung der Parameterbestimmungseinrichtung (21) zugeführt wird und dass die Parameterbestimmungseinrichtung (21) die Abfragefrequenz (freq) anhand des Abfragesignals (req) selbsttätig ermittelt.

12. Sensoreinrichtung nach einem der obigen Ansprüche,
**dadurch gekennzeichnet,**
**dass** das Erregersignal (E), bezogen auf die Abfolge der Zählerstände (Z), mit dem Modulowert (L) periodisch ist und dass das Erregersignal (E), bezogen auf die Abfolge der Zählerstände (Z), mit der Grundschwingung oder einer höheren harmonischen Schwingung oszilliert oder die Grundschwingung oder die höhere harmonische Schwingung zumindest den dominanten Anteil des Erregersignals (E) bestimmen.

13. Sensoreinrichtung nach einem der obigen Ansprüche,
**dadurch gekennzeichnet,**

- **dass** die Auswertungseinrichtung (11), gerechnet ab dem zuletzt abgefragten resultierenden Sensorsignal (S), für jeweils eine Anzahl von Zählerständen (Z) ein vorläufiges Sensorsignal (S") ermittelt,
- **dass** die soeben genannte Anzahl von Zählerständen (Z) gleich dem Modulowert (L) ist,
- **dass** die Auswertungseinrichtung (11) das jeweilige vorläufige Sensorsignal (S") dadurch ermittelt, dass sie zunächst anhand der Rohsignale (S') ein Zwischensignal (I) ermittelt und anhand des jeweiligen Zwischensignals (I) unter Verwertung einer nichtlinearen Kennlinie (KL) das jeweilige vorläufige Sensorsignal (S") ermittelt, und
- **dass** die Auswertungseinrichtung (11) das resultierende Sensorsignal (S) als Mittelwert der seit dem zuletzt abgefragten resultierenden Sensorsignal (S) ermittelten vorläufigen Sensorsignale (S") ermittelt.

**14.** Sensoreinrichtung nach einem der obigen Ansprüche,
**dadurch gekennzeichnet,**
**dass** das Sensorelement (8) als auf kapazitiver Basis arbeitendes Sensorelement ausgebildet ist, insbesondere als kapazitiver Lagegeber oder als kapazitiver Beschleunigungssensor.

## Claims

**1.** Sensor device,

- wherein the sensor device has a signal connection (2), via which a digital request signal (req) can be supplied to the sensor device from a higher-level device (3), such that the request signal (req) has alternating leading and trailing edges,
- wherein the sensor device is configured to output a resultant sensor signal (S) to the higher-level device (3) in response to supply of the digital request signal (req) via the signal connection (2) or another signal connection (2'),
- wherein the sensor device has a clock generator (5) which is configured to output a digital basic signal (clk) with a basic frequency (fclk), such that the basic signal (clk) has alternating leading and trailing edges,
- wherein the sensor device has a counter (6), to which the basic signal (clk) and the request signal (req) are supplied and which is configured to output a counter reading (Z),
- wherein the counter (6), provided no leading and/or trailing edge of the request signal (req) occurs between two directly successive leading and/or trailing edges of the basic signal (clk), is configured to increment the counter reading (Z) modulo of a modulo value (L),
- wherein the counter (6) is configured, provided a leading and/or trailing edge of the request signal (req) occurs between two directly successive leading and/or trailing edges of the basic signal (clk), to correct the counter reading (Z), prior to or after incrementation of the counter reading (Z), by the distance between the counter reading (Z) and the next one of a number of particular counter readings (Za),
- wherein the particular counter readings (Za) are a true subset of the possible counter readings (Z),
- wherein the sensor device has an exciter device (7) which is configured to output an excitation signal (E) to a sensor element (8) of the sensor device,
- wherein the respective counter reading (Z) or a value derived therefrom is supplied to the exciter device (7) and the exciter device (7) is configured to determine, on the basis of the respective counter reading (Z) or the value derived therefrom, what value the excitation signal (E) has in each case,
- wherein the sensor element (8) is configured to output a raw signal (S') on the basis of the excitation signal (E),
- wherein the sensor device has an evaluation device (11) to which the raw signal (S') is supplied,
- wherein the respective counter reading (Z) or a value derived therefrom is supplied to the evaluation device (11) and the evaluation device (11) is configured to determine, on the basis of the respective counter reading (Z) or the value derived therefrom, whether to acquire the raw signal (S') and in what way to take account of the respectively acquired raw signal (S') when establishing the resultant sensor signal (S) .

**2.** Sensor device according to claim 1,
**characterised in that**
the number (k) of particular counter readings (Za) is 1.

**3.** Sensor device according to claim 1,
**characterised in that**
the number (k) of particular counter readings (Za) is greater than 1.

**4.** Sensor device according to claim 1, 2 or 3,
**characterised in that**

- the excitation signal (E) output by the exciter device (7) to the sensor element (8), based on the sequence of counter readings (Z), has in each case a constant value during successive, internally coherent sections of counter readings (Z),
- the sections of counter readings (Z) in each case comprise at least approximately the same number (N) of counter readings (Z),
- the number (M) of sections is an integral multiple of the number (k) of particular counter readings (Za), in particular is equal to the number (k) of particular counter readings (Za), and

- the particular counter readings (Za) lie approximately in the middle of the respective section.

5. Sensor device according to claim 4,
   **characterised in that**
   the evaluation device (11) acquires the raw signal (S') solely during specific counter readings (Zb).

6. Sensor device according to claim 5,
   **characterised in that**
   the specific counter readings (Zb) are remote from the boundaries of the successive sections.

7. Sensor device according to claim 4, 5 or 6,
   **characterised in that**

   - the modulo value (L) is equal to the product of a first and a second integer (N, M),
   - the first integer (N) is equal to the number (N) of successive counter readings (Z) during which the excitation signal (E) in each case has a constant value,
   - the second integer (M) is equal to the number (M) of sections of successive counter readings (Z) during which the excitation signal (E) in each case has a constant value, and
   - the sensor device has a parameterisation input (15), via which the first and second integers (N, M) are specifiable to the sensor device after production of the sensor device, in particular on commissioning of the sensor device.

8. Sensor device according to one of the preceding claims,
   **characterised in that**
   the sensor device has a parameterisation input (15), via which the number (k) of particular counter readings (Za) is specifiable to the sensor device after production of the sensor device, in particular on commissioning of the sensor device.

9. Sensor device according to one of the preceding claims,
   **characterised in that**
   the sensor device has a parameterisation input (15), via which at least one operating parameter of the exciter device (7) and/or of the sensor element (8) and/or of the evaluation device (11) is specifiable to the sensor device after production of the sensor device, in particular on commissioning of the sensor device.

10. Sensor device according to one of the preceding claims,
    **characterised in that**
    the sensor device has a parameter determination device (21), by means of which the sensor device automatically establishes at least one operating parameter of the sensor device on the basis of the request frequency (freq).

11. Sensor device according to claim 10,
    **characterised in that**
    the sensor device has a parameterisation input (15), via which the request frequency (freq) is specifiable as such to the sensor device after production of the sensor device, in particular on commissioning of the sensor device, or **in that** the request signal (req) is supplied to the parameter determination device (21) within the sensor device and the parameter determination device (21) automatically establishes the request frequency (freq) on the basis of the request signal (req).

12. Sensor device according to one of the preceding claims,
    **characterised in that,**
    based on the sequence of the counter readings (Z), the excitation signal (E) is periodic with the modulo value (L) and **in that**, based on the sequence of counter readings, the excitation signal (E) oscillates with the fundamental component or a higher harmonic oscillation, or the fundamental component or the higher harmonic oscillation determines at least the dominant component of the excitation signal.

13. Sensor device according to one of the preceding claims,
    **characterised in that**

    - the evaluation device (11), calculated from the last requested resultant sensor signal (S), establishes a provisional sensor signal (S") for in each case a number of counter readings (Z),

- the just stated number of counter readings (Z) is equal to the modulo value (L)
- the evaluation device (11) establishes the respective provisional sensor signal (S") **in that** it initially establishes an intermediate signal (I) on the basis of the raw signals (S') and establishes the respective provisional sensor signal (S") on the basis of the respective intermediate signal (I), using a non-linear characteristic curve (KL), and
- the evaluation device (11) establishes the resultant sensor signal (S) as an average of the provisional sensor signals (S") established since the last requested resultant sensor signal (S).

**14.** Sensor device according to one of the preceding claims,
**characterised in that**
the sensor element (8) is embodied as a sensor element operating on a capacitive basis, in particular as a capacitive position encoder or as a capacitive acceleration sensor.

**Revendications**

**1.** Dispositif capteur,

- dans lequel le dispositif capteur a une borne (2) de signal, par laquelle un signal (req) numérique de demande peut être envoyé au dispositif capteur par un dispositif (3) supérieur hiérarchiquement, de manière à ce que le signal (req) de demande ait des fronts ascendants et descendants en alternance,
- dans lequel le dispositif capteur est conçu pour, en réaction à l'envoi du signal (req) numérique de demande par la borne (2) de signal ou par une autre borne (2') de signal, envoyer un signal (S) résultant de capteur au dispositif (3) supérieur hiérarchiquement,
- dans lequel le dispositif capteur a une horloge (5), qui est conçue pour donner un signal (clk) numérique de base à une fréquence (fclk) de base, de manière à ce que le signal (clk) de base ait des fronts ascendants et descendants en alternance,
- dans lequel le dispositif capteur a un compteur (6), auquel sont envoyés le signal (clk) de base et le signal (req) de demande et qui est conçu pour donner une position (Z) de compteur,
- dans lequel le compteur (6) est conçu pour, dans la mesure où il ne se produit pas entre deux fronts ascendants et/ou descendants se suivant immédiatement du signal (clk) de base, des fronts ascendants et/ou descendants du signal (req) de demande, augmenter la position (Z) du compteur modulo d'une valeur (L) modulo,
- dans lequel le compteur (6) est conçu pour, dans la mesure où il se produit entre deux fronts ascendants et/ou descendants se succédant immédiatement du signal (clk) de base, un front ascendant et/ou descendant du signal (req) de demande, corriger avant ou après l'augmentation de la position (Z) du compteur, corriger la position (Z) du compteur de la distance de la position (Z) du compteur à la plus proche d'un nombre de positions (Za) particulières du compteur,
- dans lequel les positions (Za) particulières du compteur sont un sous-ensemble réel des positions (Z) possibles du compteur,
- dans lequel le dispositif capteur a un dispositif (7) d'excitation, qui est conçu pour envoyer un signal (E) d'excitation à un élément (8) capteur du dispositif capteur,
- dans lequel la position (Z) respective du compteur ou une valeur qui s'en déduit est envoyée au dispositif (7) d'excitation et le dispositif (7) d'excitation est conçu pour, à l'aide de la position (Z) respective du compteur ou de la valeur qui s'en déduit, déterminer la valeur (K), qu'a respectivement le signal (E) d'excitation,
- dans lequel l'élément (8) capteur est conçu pour donner, sur la base du signal (E) d'excitation, un signal (S') brut,
- dans lequel le dispositif capteur a un dispositif (11) d'exploitation, auquel le signal (S') brut est envoyé,
- dans lequel la position (Z) respective du compteur ou une valeur qui s'en déduit est envoyée au dispositif (11) d'exploitation et le dispositif (11) d'exploitation est conçu pour, à l'aide de la position (Z) respective du compteur ou de la valeur qui s'en déduit, déterminer s'il détecte le signal (S') brut et de quelle façon il prend en compte le signal (S') brut détecté respectivement lors de la détermination du signal (S) de capteur résultant.

**2.** Dispositif capteur suivant la revendication 1,
**caractérisé en ce que**
le nombre (k) de positions (Za) particulières du compteur est de 1.

**3.** Dispositif capteur suivant la revendication 1,
**caractérisé en ce que**
le nombre (k) de positions (Za) particulières du compteur est plus grand que 1.

**4.** Dispositif capteur suivant la revendication 1, 2 ou 3, **caractérisé**

- **en ce que** le signal (E) d'excitation donné à l'élément (8) capteur par le dispositif (7) d'excitation a, rapporté à la suite des positions (Z) du compteur pendant des segments successifs en soi continus de positions (Z) du compteur, respectivement une valeur constante,
- **en ce que** les segments de positions (Z) du compteur comprennent respectivement au moins approximativement le même nombre (N) de position (Z) du compteur,
- **en ce que** le nombre (M) de segments est un multiple en nombre entier du nombre (k) de positions (Za) particulières du compteur en étant notamment égal au nombre (k) de positions (Za) particulières du compteur,
- **en ce que** les positions (Za) particulières du compteur se trouvent à peu près au milieu du segment respectif.

**5.** Dispositif capteur suivant la revendication 4,
**caractérisé en ce que**
le dispositif (11) d'exploitation détecte le signal (S') brut exclusivement à certaines positions (Zb) du compteur.

**6.** Dispositif capteur suivant la revendication 5,
**caractérisé en ce que**
certaines positions (Zb) du compteur sont loin des limites des segments successifs.

**7.** Dispositif capteur suivant la revendication 4, 5 ou 6, **caractérisé**

- **en ce que** la valeur (L) modulo est égale au produit d'un premier par un deuxième nombre (N, M) entier,
- **en ce que** le premier nombre (N) entier est égal au nombre (N) de positions (Z) successives du compteur, pendant lesquels le signal (E) d'excitation a respectivement une valeur constante,
- **en ce que** le deuxième nombre (M) entier est égal au nombre (M) de segments de positions (Z) successives du compteur pendant lesquelles le signal (E) d'excitation a respectivement une valeur constante, et
- **en ce que** le dispositif capteur a une entrée (15) de paramétrage, par laquelle le premier et le deuxième nombres (N, M) entiers peuvent être prescrits au dispositif capteur après la fabrication du dispositif capteur, notamment à la mise en service du dispositif capteur.

**8.** Dispositif capteur suivant l'une des revendications précédentes,
**caractérisé en ce que**
le dispositif capteur a une entrée (15) de paramétrage, par laquelle le nombre (k) de positions (Za) particulières du compteur peut être prescrit au dispositif capteur après la fabrication du dispositif capteur, notamment à la mise en service du dispositif capteur.

**9.** Dispositif capteur suivant l'une des revendications précédentes,
**caractérisé en ce que**
le dispositif capteur a une entrée (15) de paramétrage, par laquelle au moins un paramètre de fonctionnement du dispositif (7) d'excitation et/ou de l'élément (8) capteur et/ou du dispositif (11) d'exploitation peut être prescrit au dispositif capteur après la fabrication du dispositif capteur, notamment à la mise en service du dispositif capteur.

**10.** Dispositif capteur suivant l'une des revendications précédentes,
**caractérisé en ce que**
le dispositif capteur a un dispositif (21) de détermination de paramètre, au moyen duquel le dispositif capteur détermine automatiquement au moins un paramètre de fonctionnement du dispositif capteur à l'aide de la fréquence (freq) de demande.

**11.** Dispositif capteur suivant la revendication 10,
**caractérisé en ce que**
le dispositif capteur a une entrée (15) de paramétrage, par laquelle le fréquence (freq) de demande peut être prescrite en tant que telle au dispositif capteur après la fabrication du dispositif capteur, notamment à la mise en service du dispositif capteur, ou **en ce que** le signal (rec) de demande est envoyé dans le dispositif capteur au dispositif (21) de détermination de paramètre et **en ce que** le dispositif (21) de détermination de paramètre détermine automatiquement la fréquence (freq) de demande à l'aide du signal (req) de demande.

**12.** Dispositif capteur suivant l'une des revendications précédentes,
**caractérisé en ce que**

le signal (E) d'excitation, rapporté à la suite des positions (Z) du compteur, est périodique en ayant la valeur (L) modulo et **en ce que** le signal (E) d'excitation rapporté à la suite des positions (Z) du compteur, oscille à l'oscillation fondamentale ou à une oscillation harmonique plus grande ou l'oscillation fondamentale ou l'oscillation harmonique plus grande détermine au moins la proportion prépondérante du signal (E) d'excitation.

13. Dispositif capteur suivant l'une des revendications précédentes,
   **caractérisé**

   - **en ce que** le dispositif (11) d'exploitation détermine, décompté à partir du signal (S) de capteur résultant demandé en dernier, pour respectivement un nombre de positions (Z) du compteur un signal (S") provisoire de capteur,
   - **en ce que** le nombre, qui vient d'être mentionné de positions (Z) du capteur, est égal à la valeur (L) modulo,
   - **en ce que** le dispositif (11) d'exploitation détermine le signal (S") provisoire respectif de capteur en déterminant d'abord, à l'aide des signaux (S') bruts un signal (I) intermédiaire et détermine à l'aide du signal (I) respectif intermédiaire, en utilisant une courbe (KL) caractéristique non linéaire, le signal (S") respectif provisoire, et
   - **en ce que** le dispositif (11) d'exploitation détermine le signal (S) résultant de capteur comme valeur moyenne des signaux (S") provisoires de capteur déterminés depuis le signal (S) résultant de capteur demandé en dernier.

14. Dispositif capteur suivant l'une des revendications précédentes,
   **caractérisé en ce que**
   l'élément (8) capteur est constitué sous la forme d'un élément capteur travaillant sur une base capacitive, notamment sous la forme d'un donneur capacitif de position ou d'un capteur capacitif d'accélération.

FIG 1

15

N, M, k, ...

3

4

1

5

req

2

clk

S

2'

6   Z

$Treq = \dfrac{1}{freq}$

$Tclk = \dfrac{1}{fclk}$

# FIG 2

FIG 3

S1: $\int_{clk}$?

S2: $\int_{req}$?

S3: $Z=L-1$?

S4: $Z=0$

S5: $Z=Z+1$

S6: $Za: MIN(|Z-Za|, L-|Z-Za|) \rightarrow min$

S7: $Z=Za$

## FIG 4

L/2    L/2

0    L=2000    Z

## FIG 5

L/4    L/4    L/4    L/4

0    L=2000    Z

## FIG 6

E

Za    Za    Za    Za    Za    Za    Za    Za    Za

0    250    500    750    1000    1250    1500    1750    2000    Z

## FIG 7

## FIG 8

FIG 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2916107 A1